# EUROPÄISCHE PATENTSCHRIFT

(11) **EP 0 310 183 B1**
(45) Veröffentlichungstag und Bekanntmachung des Hinweises auf die Patenterteilung: **10.01.1996**
(21) Anmeldenummer: 88202083.7
(22) Anmeldetag: 26.09.1988
(51) Int. Cl.: G03F 1/00

(54) **Verfahren zur Herstellung eines Maskenträgers aus SIC für Röntgenstrahllithographie-Masken**
Fabrication process of a SiC mask support for X-ray lithography
Procédé pour la fabrication d'un support de masque en SiC, pour la lithographie aux rayons X

(30) Priorität: 02.10.1987 DE 3733311
(43) Veröffentlichungstag der Anmeldung: 05.04.1989
(73) Patentinhaber: Philips Patentverwaltung GmbH, D-22335 Hamburg (DE); Philips Electronics N.V., NL-5621 BA Eindhoven (NL)
(72) Erfinder: Bruns, Angelika, D-2359 Henstedt-Ulzburg (DE); Harms, Margret, D-2000 Hamburg 61 (DE); Lüthje, Holger, Dipl.-Ing., D-2083 Halstenbek (DE); Matthiessen, Bernd, Dipl.-Ing., D-2105 Seevetal (DE)
(74) Vertreter: Volmer, Georg, Dipl.-Ing.

(56) Entgegenhaltungen:
- EP-A- 0 244 496
- GB-A- 2 100 713
- US-A- 4 608 326
- DATABASE WPIL, No 72-35722T, Derwent
- && JP-B-47 018563 (MATSUSHITA ELECTRIC IND C) 1972
- PATENT ABSTRACTS OF JAPAN vol. 12, no. 77 (E-589)(2924) 10 März 1988,& JP-A-62 216325 (FUJITSU LTD) 22 September 1987,
- Proceedings of SPIE-The International Society for Optical Engineering, vol 923,p9-15, Electron-Beam, X-Ray and Ion-Beam Technology: SubmicrometerLithographies VII, 2-4 March 1988 Santa Clara, Ca, US; U. MACKENS et al.:"Application of SiC-X-Ray masks for fabricating sub-micron devices".

## Beschreibung

Die Erfindung betrifft ein Verfahren zur Herstellung eines Maskenträgers (Membran) aus SiC für Röntgenstrahllithographie-Masken, wobei eine SiC-Schicht mittels chemical vapour deposition (CVD) auf einem Substrat in Form einer Silicium-Einkristallscheibe auf mindestens einer der beiden Hauptflächen der Silicium-Einkristallscheibe abgeschieden wird, wonach die Silicium-Einkristallscheibe bis auf einen Randbereich in einem selektiven Ätzschritt entfernt wird.

Mit der Arbeit von E. Spiller und R. Feder "X-ray lithography" in "Topics in current physics: X-ray optics", Springer, New York, 1977, Seiten 35 bis 92, wird gezeigt, welche Bedeutung die Röntgenstrahllithographie bei der Herstellung von z.B. Halbleitersystemen oder magnetischen Zylinderdomänen-Anordnungen hat, da insbesondere bei diesen Fertigungsprozessen zunehmend immer kleiner werdende Strukturen im pm- oder nm-Bereich Bedeutung erlangen. Für alle Verfahren mit hoher Auflösung sind genaue und äußerst präzise definierte Masken erforderlich. Die Leistungsfähigkeit der Röntgenstrahllithographie wird deutlich an der minimalen Streifenbreite der Strukturen, die mit ihr zu erreichen ist: Lichtlithographie ≈ 2 bis 3 µm, Elektronenstrahllithographie ≈ 0,05 bis 0,1 µm, Röntgenstrahllithographie < 500 nm.

Die Anwendung von Röntgenstrahlen zur Belichtung eines zu strukturierenden Lackes bringt den Vorteil, daß störende Beugungserscheinungen bei der Projektion der Maskenstrukturen auf die Lackschicht herabgesetzt werden.

Für die Belichtung mit Röntgenstrahlen sind spezielle Bestrahlungsmasken zur Strukturerzeugung im Lack erforderlich; eine solche Maske besteht aus dem Muster der herzustellenden Struktur aus einem stark Röntgenstrahlen absorbierenden Material (Absorber), wobei das Absorbermuster auf einer dünnen Membran aus einem für Röntgenstrahlen möglichst hochtransparenten Material angebracht ist.

Für den Absorber kommen Materialien mit einem möglichst hohen Atomgewicht in Betracht; in der Praxis bewährt haben sich z.B. Gold, Molybdän oder Wolfram.

Als Material für die Membran kommen praktisch alle Materialien in Betracht, die hinlänglich transparent für Röntgenstrahlen sind. Da im Röntgenstrahlenbereich jedoch kein Material vollständig transparent und kein Material vollständig opak ist, sollte die Membran relativ dünn sein, um eine möglichst große Transparenz für Röntgenstrahlen zu gewährleisten; das Absorbermuster sollte relativ dick sein, um eine möglichst hohe Absorption von Röntgenstrahlen sicherzustellen.

Durch geeignete Wahl der Materialien und der Herstellungsprozesse muß einerseits sichergestellt werden, daß die Masken sowohl hinsichtlich der Röntgenstrahlung (relativ weiche Röntgenstrahlung einer Wellenlänge im Bereich von λ= 0,5 bis 2 nm) als auch hinsichtlich der zur Justierung erforderlichen Strahlung aus dem sichtbaren Bereich des Spektrums hinreichend transparent sind. Die dadurch limitierte Membrandicke liegt im Bereich von wenigen Mikrometern. Andererseits müssen die Masken zur Strukturvervielfältigung einen ausreichenden Kontrast aufweisen. Da auch schwere Elemente, aus denen die Absorberstrukturen gebildet werden, gegenüber Röntgenstrahlung keinesfalls völlig opak sind, müssen die Absorberstrukturen im allgemeinen in einer Dicke von nahezu 1 µm appliziert werden. Diese Bedingungen zu realisieren stellt die Fertigungstechnik bereits vor nicht unerhebliche Schwierigkeiten.

Die zunehmend kleiner werdenden Strukturen von Bauelementen, die mittels Röntgenstrahllithographie hergestellt werden, erfordern darüberhinaus Masken, deren Maßgenauigkeit in nur noch sehr engen Toleranzgrenzen (≤ 100 nm) schwanken dürfen. Damit steht die Fertigungstechnik vor erheblichen Problemen, denn diese engen Toleranzgrenzen müssen trotz vieler sehr unterschiedlicher Prozeßschritte für die Herstellung der Masken und auch über eine lange Lebensdauer der Masken mit bis zu 106 Belichtungen pro Maske mit intensiver Röntgenbestrahlung erhalten bleiben. Diese Anforderungen lassen den hohen Stellenwert erkennen, der der mechanischen Stabilität der Membran zukommt.

Die mechanische Stabilität einer Membran kann durch deren Elastizitätsmodul charakterisiert werden. In der nachfolgenden Tabelle sind der Elastizitätsmodul und weitere Eigenschaften unterschiedlicher bekannter Membran-Materialien dargestellt.

| Material | thermische Ausdehnung (K⁻¹) | Elastizitätsmodul (N/m) | Brechnungsindex | Dichte (g/cm³) |
|---|---|---|---|---|
| SiC | 4,7.10⁻⁶ | 4,57.10¹¹ | 2,48 | 3,2 |
| Si | 2,6.10⁻⁶ | 1,62.10¹¹ | 3,9 | 2,42 |
| Si₃N₄ | 2,7.10⁻⁶ | 1,55.10¹¹ | 2,2 | - |
| BN | 1.10⁻⁶ | 1,33.10¹¹ | 2,0 | 2,34 |
| Be | 12,3.10⁻⁶ | 3,02.10¹¹ | - | 1,85 |
| Mg | 26.10⁻⁶ | 0,45.10¹¹ | - | 1,74 |
| Ti | 9.10⁻⁶ | 1,1.10¹¹ | - | 4,52 |

Aus der Tabelle geht hervor, daß SiC wegen seines hohen Elastizitätsmoduls, aber auch wegen seiner optischen Eigenschaften ein besonders geeignetes Material für Membranen für Röntgenstrahllithographie-Masken ist.

Neben der erforderlichen mechanischen Steifigkeit spielen außerdem jedoch die Topographie (Oberflächenrauhigkeit oder Rauhtiefe) und induzierte Spannungen eine wesentliche Rolle. Mit den bekannten Beschichtungsverfahren zur Herstellung von SiC-Schichten ist es bisher nicht möglich, eine für optimale SiC-Membranen erforderliche geringe Zugspannung neben einer geringen Rauhtiefe während der Herstellung der Membranen zu erreichen.

Aus US-PS 3 873 824 ist eine Maske für Röntgenstrahllithographie bekannt, die einen Maskenträger aus SiC auf einem Körper aus vorzugsweise Silicium aufweist.

Der nach dem bekannten Verfahren hergestellte Maskenträger weist jedoch noch eine zu hohe Rauhtiefe und eine zu hohe Zugspannung auf.

Weiterhin ist aus Patent Abstracts of Japan, Band 12, No. 77, (E-589), 10.03. 1988 & JP-A-62-216 325 ein Herstellungsverfahren für eine Röntgenmaske bekannt, bei dem ein β-SiC-Film auf einer Siliziumeinkristallscheibe durch ein CVD-Verfahren abgeschieden wird. Die Abscheidung erfolgt durch gemeinsames Einwirken von SiHCl₃ -Gas und C₃H₈ - Gas auf die aufgeheizte Siliziumscheibe. Auch derartig hergestellte Masken haben noch eine zu hohe Zugspannung.

Zur Reduzierung solcher Zugspannungen schlägt die US 4,608,326 vor, zwischen dem Siliziumeinkristall-Substrat und der SiC-Maske eine amorphe Zwischenschicht aus Siliziumdioxid oder Siliziumnitrid durch ein konventionelles CVD-Verfahren aufzubringen. Eine derartig hergestellte Maske weist eine Schichtstruktur auf. Eine Schichtstruktur aus Materialien mit unterschiedlichem Brechungsindex beeinflusst jedoch die optischen Eigenschaften der Maske negativ.

Der Erfindung liegt daher die Aufgabe zugrunde, ein Verfahren zur Herstellung von SiC-Membranen zu schaffen, das nicht nur zu glatten, sondern auch zu in gewünschter Weise spannungsarmen, im Bereich des sichtbaren Spektrums hochtransparenten SiC-Membranen führt.

Diese Aufgabe wird erfindungsgemäß dadurch gelöst, daß ein durch folgende Verfahrensschritte gekennzeichnetes Verfahren angewendet wird:

a) Abscheidung der SiC-Schicht, wobei die Silicium-Einkristallscheibe in der für den Abscheidungsprozeß vorgesehenen Vorrichtung zunächst auf eine Temperatur im Bereich von 1000 bis 1350 °C unter einer H₂-Atmosphäre aufgeheizt wird, danach mit einem geeigneten Ätzmittel angeätzt wird, danach unter Einfluß von H₂ gespült wird und anschließend die SiC-Schicht aus einer Silicium und Kohlenwasserstoffe enthaltenden Gasatmosphäre angebracht wird, wonach das beschichtete Substrat auf Raumtemperatur unter H₂-Atmosphäre abgekühlt wird und
b) Implantation von Ionen in die SiC-Schicht zur mechanischen Störung der Kristallstruktur der SiC-Schicht.

Mit dem ersten Prozeßschritt gemäß a) werden infolge dergewählten Reaktionstemperatur SiC-Schichten hoher Zugspannung im Bereich von x.10⁸N/m und geringer Rauhtiefe im nm-Bereich erreicht, mit dem weiteren Prozeßschritt gemäß b) können infolge der Implantation von Ionen, die die Kristallstruktur der SiC-Schicht mechanisch stören, die Zugspannungswerte in einem Bereich von x.10⁷N/m eingestellt werden.

Aus der GB 2 100 713 A ist es zwar bekannt, die Härte und die bruchmechanischen Eigenschaften von kompakten SiC-Körpern für Lager und Dichtungen durch Implantation mit Stickstoffionen zu modifizieren. Dabei wird eine Oberflächenschicht gebildet, die eine erhöhte Plastizität hat. In diesem Anwendungsgebiet treten jedoch die induzierten Zugspannungen, die bei der Abscheidung von Siliziumcarbidschichten auf Siliziumeinkristall-Substraten durch ein CVD-Verfahren entstehen, nicht auf.

Nach einer vorteilhaften Weiterbildung des Verfahrens nach der Erfindung wird die Silicium-Einkristallscheibe auf eine Temperatur von 1110 °C aufgeheizt.

Nach weiteren vorteilhaften Ausbildungen des Verfahrens nach der Erfindung werden als Reaktionsgas zur Abscheidung der SiC-Schicht 0,05 bis 8,0%, vorzugsweise 1,4% Dichlordimethylsilan (CH₃)₂SiCl₂ in Wasserstoff H₂, zuzüglich 15% Propan, bezogen auf Dichlordimethylsilan, oder Silan SiH₄ mit Toluol C₇H₈ oder Silan SiH₄ mit Propan C₃H₈ eingesetzt.

Nach weiteren vorteilhaften Ausgestaltungen des Verfahrens gemäß der Erfindung werden in die SiC-Schicht Borionen mit einer Dosis von 10¹⁵ bis 10¹⁶/cm, vorzugsweise 10¹⁶/cm, bei einer Implantations-Energie im Bereich von 150 bis 400 keV, vorzugsweise von 170 keV, oder Kohlenstoffionen mit einer Dosis von 10¹⁵ bis 5.10¹⁶/cm, vorzugsweise 10¹⁶/cm, bei einer Implantationsenergie im Bereich von 150 bis 400 keV, vorzugsweise 400 keV, oder Stickstoffionen mit einer Dosis von 10¹⁵ bis 5.10¹⁶/cm, vorzugsweise 2.10¹⁶/cm bei einer Implantationsenergie im Bereich von 150 bis 400 keV, vorzugsweise 400 keV, implantiert.

Die mit der Erfindung erzielbaren Vorteile bestehen insbesondere darin, daß SiC-Schichten mit geringer Rauhtiefe und gleichzeitig verminderter Zugspannung reproduzierbar und mit definiert einstellbaren Spannungswerten hergestellt werden können. Ein weiterer erheblicher Vorteil in ökonomischer Sicht ist darin zu sehen, daß sowohl der für die Herstellung der SiC-Schicht vorgesehene CVD-Prozeß als auch der für die Verringerung der Spannung innerhalb der SiC-Schicht vorgesehene Ionenimplantationsprozeß mit kommerziell erhältlichen Maschinen ausführbar ist.

Anhand der Zeichnung werden Ausführungsbeispiele der Erfindung beschrieben und in ihrer Wirkungsweise erläutert. Es zeigen:
- Fig. 1: schematische Darstellung des Prozeßablaufes der Beschichtung eines Substrates mit einer SiC-Schicht und Ausbilden einer SiC-Membran nach Entfernen eines Teils des Substrates,
- Fig. 2: Diagramm der Spannung in nach dem vorliegenden Verfahren hergestellten SiC-Schichten in Abhängigkeit von der Reaktionstemperatur und vom Propangehalt in der Gasatmosphäre,
- Fig. 3: Diagramm der Rauhtiefe von nach dem vorliegenden Verfahren hergestellten SiC-Schichten in Abhängigkeit von der Reaktionstemperatur und vom Propangehalt in der Gasatmosphäre.

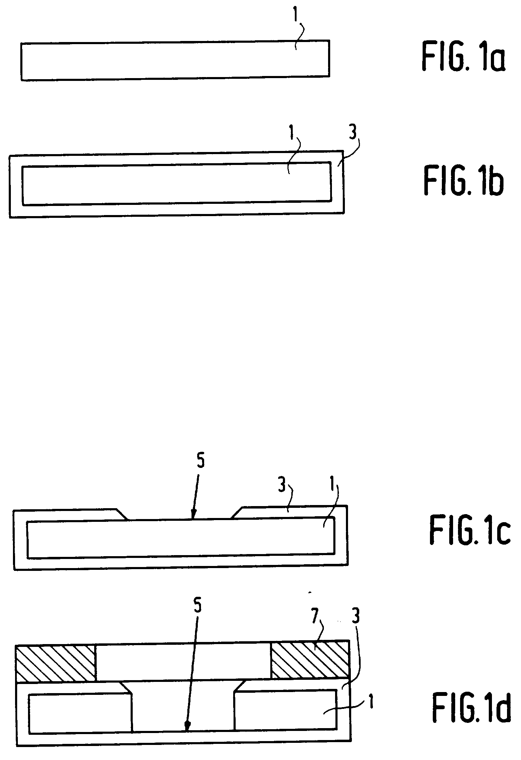

In Figur 1 ist schematisch der Ablauf des Herstellungsprozesses für eine SiC-Membran mit den Fertigungsschritten a) bis d) dargestellt.

Als Substrat 1 dient eine handelsübliche Silicium-Einkristallscheibe mit [100] -Orientierung, auf der allseitig eine 2,5 µm dicke SiC-Schicht 3 abgeschieden wird (Figuren 1a, 1b). Der gewünschte Membranbereich 5 wird durch eine mechanische Maske (nicht dargestellt) definiert und die SiC-Schicht 3 wird durch reaktives Ionenätzen in SF₆-Atmosphäre in diesem Bereich entfernt (Figur 1c). Das Substrat 1 wird dann in einem selektiv wirkenden Ätzmittel (KOH) naßchemisch im Membranbereich 5 entfernt. Die Fertigstellung erfolgt durch Aufkleben des ausgeätzten Substrates 1 auf einen 5 mm dicken Glasring 7 (Figur 1d).

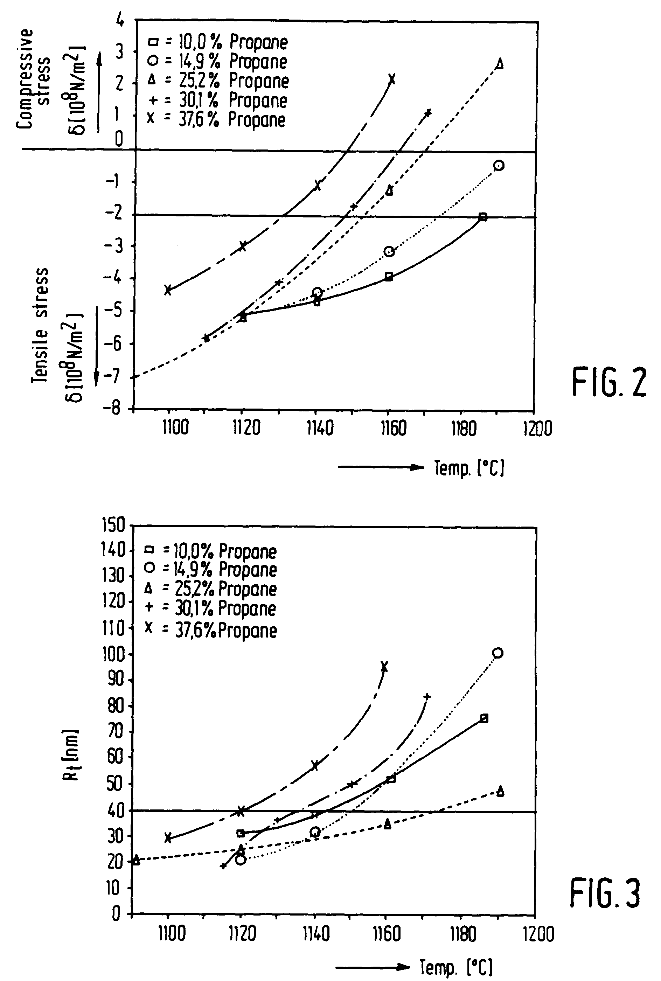

Da die Qualität der Membran im wesentlichen durch den Beschichtungsprozeß beeinflußt wird, kommt der SiC-Abscheidung eine besondere Bedeutung zu. Neben der erwünschten mechanischen Steifigkeit sind weitere, für die Anwendung als Maske essentielle Kriterien durch die Spannung und die Topographie (Rauhtiefe) der SiC-Schicht gegeben. Es zeigte sich, daß bei ausreichender Konzentration von Silicium und Kohlenwasserstoffen im Reaktionsgas (z.B. Dichlordimethylsilan (CH₃)₂SiCl₂ und Propan C₃H₈ in H₂ als Trägergas) die Schichteigenschaften erheblich durch die Beschichtungstemperatur und die am Prozeß beteiligte Propanmenge, die als Kohlenstoffquelle dient, beeinflußt werden können. Dieser Sachverhalt ist in Figur 2 anhand der Schichtspannung dargestellt worden. Mit steigender Temperatur erfolgt eine Verringerung der Zugspannung in Richtung auf eine gegenläufige Druckspannung. Allgemein verschiebt sich die Temperatur zur Erzielung spannungsarmer SiC-Schichten mit zunehmendem Propangehalt in tiefere Bereiche.

Vergleichbare Ergebnisse wurden auch mit Silan SiH₄ und Toluol C₇H₈ bzw. mit Silan SiH₄ und Propan C₃H₈ gewonnen.

Eine Analyse von Schichten, die dem Zugspannungsbereich in Figur 2 zuzuordnen sind, lassen einheitlich auf eine polykristalline Struktur schließen, die im wesentlichen β-orientiert ist. Die Wasserstoff- und Chlorkonzentration lag in allen Fällen unter 3 Atom%, unabhängig vom Propangehalt. Der Elastizitätsmodul wurde zu 4,6.10¹¹N/m bestimmt. Hinsichtlich der optischen Transparenz wurden im Wellenlängenbereich zwischen 700 bis 800 nm an 2,5 µm dicken Schichten Werte von mehr als 50% gemessen, die durch eine Antireflexbeschichtung auf über 80% angehoben werden können.

Da der polykristallinen Struktur der SiC-Schicht eine Oberflächenrauhigkeit (Rauhtiefe) immanent ist, wurde auch diese Eigenschaft ausführlich untersucht. Die mechanisch mit Hilfe eines Abtastsystems ermittelte Rauhtiefe (Rₜ) ist in Figur 3 in Abhängigkeit von der Reaktionstemperatur aufgetragen. Auch in diesem Fall zeigt sich eine erhebliche Beeinflussung der Rₜ-Werte durch die Reaktionstemperatur und den Propangehalt. Da die Optimierung des CVD-Prozesses jedoch sowohl im Hinblick auf eine geringe Zugspannung (σ ≈ 5.10⁷N/m) als auch auf eine geringe Rauhtiefe (Rₜ < 20 nm) erfolgen muß, lassen sich entweder nur relativ rauhe Schichten, die die Justier- und die Strukturqualität der Maske erheblich limitieren, oder aber glatte Schichten (Rₜ ≈ 10 nm) mit verhältnismäßig hoher Zugspannung ( σ ≈ 5.10⁸N/m) herstellen. Im zweiten Fall wirkt sich neben einer geringen Ausbeute an Maskenträgern (Membranen) insbesondere die durch die Zugspannung bedingte Unebenheit dieser Membranen nachteilig aus. Ein weiterer Nachteil ist ferner in der beträchtlichen Streuung der Zugspannungswerte im Bereich σ < 10⁸N/m zu sehen.

Um nun sowohl glatte als auch nahezu spannungsfreie SiC-Schichten zu erreichen, wird die erfindungsgemäße Membran in zwei Prozeßschritten hergestellt, wobei im ersten Schritt eine SiC-Schicht 3 (vgl. Figuren 2 und 3) mit hoher Zugspannung, jedoch sehr geringer Rauhtiefe auf der Silicium-Einkristallscheibe 1 abgeschieden wird, die im zweiten Schritt des Verfahrens mit Hilfe eines Ionenimplantationsprozesses durch geeignete Prozeßführung hinsichtlich der mechanischen Spannung justiert wird. Die Schichtspannung ist also unabhängig von den Parametern zur Abscheidung der Schicht in definierter Weise einstellbar.

Zur Herstellung einer 2,5 µm dicken SiC-Schicht werden folgende Bedingungen angewandt:
1. Aufheizen des Substrates in Form einer [100]-orientierten Silicium-Einkristallscheibe auf eine Temperatur von 1110 °C unter H₂-Atmosphäre,
2. Anätzen des Substrates in HCl über eine Dauer von 4 min,
3. Spülen des angeätzten Substrates in H₂ über eine Dauer von 4 min,
4. SiC-Abscheidung aus einem Reaktionsgas mit 14% Dichlordimethylsilan (CH₃)₂ SiCl₂ in H₂-Trägergas, zuzüglich 15% Propan, bezogen auf Dichlordimethylsilan; Abscheidedauer 60 s,
5. Abkühlen unter H₂-Atmosphäre auf Raumtemperatur.

Die auf diese Weise hergestellte SiC-Schicht besitzt eine Rauhtiefe Rₜ < 20 nm. Die über die Substratverformung ermittelte Zugspannung beträgt ≈ 4.10⁸N/m.

Nach der Beschichtung wird das Substrat unter Anwendung einer Hochstrom-Ionenimplantationsanlage mit Bor dotiert. Außer der Implantation mit Bor wurden auch Versuche mit Stickstoff, Argon und Kohlenstoff durchgeführt. In allen Fällen konnte ein Einfluß auf die Zugspannung der SiC-Schicht beobachtet werden.

| Implantationsdaten für Bor: | |
|---|---|
| Zugspannung der abgeschiedenen SiC-Schicht: | 4.10⁸N/m |
| Implantationsenergie: | 170 keV |
| Dosis: | 10¹⁶/cm |
| Zugspannung der implantierten SiC-Schicht: | 2.10⁷N/m. |

| Implantationsdaten für Kohlenstoff: | |
|---|---|
| Zugspannung der abgeschiedenen SiC-Schicht: | 4,4.10⁸N/m |
| Implantationsenergie: | 400 keV |
| Dosis: | 10¹⁶/cm |
| Zugspannung der implantierten SiC-Schicht: | 8.10⁷N/m. |

| Implantationsdaten für Stickstoff: | |
|---|---|
| Zugspannung der abgeschiedenen SiC-Schicht: | 4.10⁸N/m |
| Implantationsenergie: | 400 keV |
| Dosis: | 2.10¹⁶/cm |
| Zugspannung der implantierten SiC-Schicht: | < 10⁸N/m |

Es kann außerdem so verfahren werden, daß die Silicium-Einkristallscheibe allseitig mit einer SiC-Schicht versehen wird, daß anschließend zunächst der entsprechend der herzustellenden Membran nicht gewünschte Mittelteil der Silicium-Einkristallscheibe mit der auf ihm befindlichen SiC-Schicht durch einen selektiven Ätzprozeß entfernt wird und daß dann anschließend in die verbliebene, der entfernten SiC-Schicht gegenüberliegende SiC-Schicht, die bereits die Membran darstellt, die gewünschten Ionen implantiert werden. In diesem Fall kann die Ionenimplantation z.B. auch von der Rückseite der Membran her erfolgen. Ist das Substrat an seinen beiden Hauptflächen mit einer SiC-Schicht versehen worden, werden die zur Verringerung der Zugspannung vorgesehenen Ionen zweckmäßigerweise auch in beide jeweils auf den Hauptflächen des Substrates befindliche SiC-Schichten implantiert.

Es kann auch so vorgegangen werden, daß die Silicium-Einkristallscheibe nur an einer ihrer Hauptflächen mit einer SiC-Schicht versehen wird und nach Implantation der gewünschten Ionen entweder eine aufgelegte Ätzmaske oder eine mittels eines Abscheidungsprozesses aus der Gasphase angebrachte Nitrid-Maske vor der teilweisen Entfernung des Silicium-Substrates mittels Ätzprozeß eingesetzt wird.

Anstelle von Bor-, Kohlenstoff- oder Stickstoff-Ionen können auch Silicium- oder Wasserstoff-Ionen in die SiC-Schicht implantiert werden. Die Implantationsdaten sind im Rahmen des vorliegenden Verfahrens vom Fachmann im Bereich der gewünschten Spannungsreduzierung zu ermitteln.

## Patentansprüche

1. Verfahren zur Herstellung eines Maskenträgers aus SiC für Röntgenstrahllithographie-Masken, wobei eine SiC-Schicht mittels chemical vapour deposition (CVD) auf einem Substrat in Form einer Silicium-Einkristallscheibe auf mindestens einer der beiden Hauptflächen der Silicium-Einkristallscheibe abgeschieden wird, wonach die Silicium-Einkristallscheibe bis auf einen Randbereich in einem selektiven Ätzschritt entfernt wird, gekennzeichnet durch folgende Verfahrensschritte:
a) Abscheidung der SiC-Schicht, wobei die Silicium-Einkristallscheibe in der für den Abscheidungsprozeß vorgesehenen Vorrichtung zunächst auf eine Temperatur im Bereich von 1000 bis 1350 °C unter einer H₂-Atmosphäre aufgeheizt wird, danach mit einem geeigneten Ätzmittel angeätzt wird, danach unter Einfluß von H₂ gespült wird und anschließend die SiC-Schicht aus einer Silicium und Kohlenwasserstoffe enthaltenden Gasatmosphäre angebracht wird, wonach das beschichtete Substrat auf Raumtemperatur unter H₂-Atmosphäre abgekühlt wird, und
b) Implantation von Ionen in die SiC-Schicht zur mechanischen Störung der Kristallstruktur der SiC-Schicht.

2. Verfahren nach Anspruch 1,
dadurch gekennzeichnet,
daß die SiC-Schicht auf beiden Hauptflächen der Silicium-Einkristallscheibe abgeschieden wird und sowohl die Silicium-Einkristallscheibe als auch die SiC-Schicht auf einer der Hauptflächen in einem selektiven Ätzschritt bis auf einen Randbereich entfernt werden.

3. Verfahren nach Anspruch 1 oder 2,
dadurch gekennzeichnet,
daß die Silicium-Einkristallscheibe vor Abscheiden der SiC-Schicht auf eine Temperatur von 1110 °C aufgeheizt wird.

4. Verfahren nach mindestens einem der Ansprüche 1 bis 3,
dadurch gekennzeichnet,
daß als Reaktionsgas zur Abscheidung der SiC-Schicht 0,05 bis 8,0%, vorzugsweise 1,4% Dichlordimethylsilan (CH₃)₂SiCl₂ in Wasserstoff H₂, zuzüglich 15% Propan C₃H₈, bezogen auf Dichlordimethylsilan, eingesetzt wird.

5. Verfahren nach mindestens einem der Ansprüche 1 bis 3,
dadurch gekennzeichnet,
daß als Reaktionsgas zur Abscheidung der SiC-Schicht Silan SiH₄ mit Toluol C₇H₈ eingesetzt wird.

6. Verfahren nach mindestens einem der Ansprüche 1 bis 3,
dadurch gekennzeichnet,
daß als Reaktionsgas zur Abscheidung der SiC-Schicht Silan SiH₄ mit Propan C₃H₈ eingesetzt wird.

7. Verfahren nach Anspruch 4,
dadurch gekennzeichnet,
daß die SiC-Schicht mit einer Dicke von 2,5 µm abgeschieden wird.

8. Verfahren nach Anspruch 7,
dadurch gekennzeichnet,
daß in die SiC-Schicht Borionen mit einer Dosis von 10¹⁵ bis 10¹⁶/cm bei einer Implantationsenergie im Bereich von 150 bis 400 keV implantiert werden.

9. Verfahren nach Anspruch 8,
dadurch gekennzeichnet,
daß in die SiC-Schicht Borionen mit einer Dosis von 10¹⁶/cm bei einer Implantationsenergie von 170 keV implantiert werden.

10. Verfahren nach Anspruch 7,
dadurch gekennzeichnet,
daß in die SiC-Schicht Kohlenstoffionen mit einer Dosis von 10¹⁵ bis 5.10¹⁶/cm bei einer Implantationsenergie im Bereich von 150 bis 400 keV implantiert werden.

11. Verfahren nach Anspruch 10,
dadurch gekennzeichnet,
daß in die SiC-Schicht Kohlenstoffionen mit einer Dosis von 10¹⁶/cm bei einer Implantationsenergie von 400 keV implantiert werden.

12. Verfahren nach Anspruch 7,
dadurch gekennzeichnet,
daß in die SiC-Schicht Stickstoffionen mit einer Dosis von 10¹⁵ bis 5.10¹⁶/cm bei einer Implantationsenergie im Bereich von 150 bis 400 keV implantiert werden.

13. Verfahren nach Anspruch 12,
dadurch gekennzeichnet,
daß in die SiC-Schicht Stickstoffionen mit einer Dosis von 2.10¹⁶/cm bei einer Implantationsenergie von 400 keV implantiert werden.

## Claims

1. A method of manufacturing a mask support of SiC for X-ray lithography masks, in which an SiC layer is deposited by means of chemical vapour deposition (CVD) on a substrate in the form of a monocrystalline silicon wafer on at least one of the two major surfaces of the monocrystalline silicon wafer, after which the monocrystalline silicon wafer is removed except for an edge region in a selective etching step, characterized by the following process steps:
a. deposition of the SiC layer, the monocrystalline silicon wafer being first heated in the apparatus provided for the deposition process to a temperature in the range of 1000 to 1350°C in a H₂ atmosphere, then being etched by means of a suitable etchant, and subsequently being flushed with H₂, whereupon the SiC layer is provided from a gas atmosphere containing silicon and hydrocarbons, after which the coated substrate is cooled to ambient temperature in a H₂ atmosphere, and
b. implantation of ions into the SiC layer for mechanically disturbing the crystal structure of the SiC layer.

2. A method as claimed in Claim 1, characterized in that the SiC layer is deposited on both main surfaces of the monocrystalline silicon wafer, and both the monocrystalline silicon wafer and the SiC layer are removed except for an edge region in a selective etching step.

3. A method as claimed in Claim 1 or 2, characterized in that the monocrystalline silicon wafer is heated to a temperature of 1110°C before deposition of the SiC layer.

4. A method as claimed in at least one of the Claims 1 to 3, characterized in that the 0.05 to 8.0 %, preferably 1.4 %, of dichlorodimethyl silane (CH₃)₂SiCl₂ in hydrogen H₂ plus 15 % of propane C₃H₈, related to the dichlorodimethyl silane is used as the reaction gas for deposition of the SiC layer.

5. A method as claimed in at least one of the Claims 1 to 3, characterized in that silane SiH₄ with toluene C₇H₈ is used as the reaction gas for the deposition of the SiC layer.

6. A method as claimed in at least one of the Claims 1 to 3, characterized in that silane SiH₄ with propane C₃H₈ is used as the reaction gas for the deposition of the SiC layer.

7. A method as claimed in Claim 4, characterized in that the SiC layer is deposited to a thickness of 2.5 µm.

8. A method as claimed in Claim 7, characterized in that boron ions are implanted into the SiC layer at a dose of 10¹⁵ to 10¹⁶/cm at an implantation energy in the range of 150 to 400 keV.

9. A method as claimed in Claim 8, characterized in that boron ions are implanted into the SiC layer at a dose of 10¹⁶/cm at an implantation energy of 170 keV.

10. A method as claimed in Claim 7, characterized in that carbon ions are implanted into the SiC layer at a dose of 10¹⁵ to 5*10¹⁶/cm at an implantation energy in the range of 150 to 400 keV.

11. A method as claimed in Claim 10, characterized in that carbon ions are implanted into the SiC layer at a dose of 10¹⁶/cm at an implantation energy of 400 keV.

12. A method as claimed in Claim 7, characterized in that nitrogen ions are implanted into the SiC layer at a dose of 10¹⁵ to 5∗10¹⁶/cm at an implantation energy in the range of 150 to 400 keV.

13. A method as claimed in Claim 12, characterized in that nitrogen ions are implanted into the SiC layer at a dose of 2∗10¹⁶/cm at an implantation energy of 400 keV.

## Revendications

1. Procédé de fabrication d'un support de masque en SiC pour des masques de lithographie aux rayons X, une couche de SiC étant déposée au moyen d'un procédé de Chemical Vapour Deposition (CVD) sur un substrat sous la forme d'une tranche monocristalline de silicium sur au moins une des deux surfaces principales de la tranche monocristalline de silicium, après quoi la couche monocristalline de silicium est enlevée jusqu'à une région de bordure dans une étape de gravure sélective,
caractérisé par les étapes suivantes :
a) dépôt de la couche de SiC, la tranche monocristalline de silicium étant d'abord portée à une température de l'ordre de 1000 à 1350°C sous atmosphère de H₂ dans le dispositif prévu pour le processus de dépôt; ensuite, la gravure est effectuée à l'aide d'un agent de gravure approprié; cette opération est suivie d'un rinçage sous l'influence de H₂ et la couche de SiC est appliquée à partir d'une atmosphère gazeuse contenant du silicium et des hydrocarbures, après quoi, le substrat revêtu est refroidi à température ambiante sous atmosphère de H₂, et
b) implantation d'ions dans la couche de SiC en vue de la perturbation mécanique de la structure cristalline de la couche de SiC.

2. Procédé selon la revendication 1, caractérisé en ce que la couche de SiC est déposée sur les deux surfaces principales de la tranche monocristalline de silicium et tant la tranche monocristalline de silicium que la couche de SiC sont enlevées d'une des surfaces principales lors d'une étape de gravure sélective jusqu'à une région de bordure.

3. Procédé selon la revendication 1 ou 2, caractérisé en ce que la tranche monocristalline de silicium est chauffée avant le dépôt de la couche de SiC à une température de 1110°C.

4. Procédé selon au moins une des revendications 1 à 3, caractérisé en ce que 0,05% à 8,0%, de préférence 1,4% de dichlorodiméthylsilane (CH₃)₂SiCl₂ dans de l'hydrogène H₂, plus 15 % de propane C₃H₈ par rapport au dichlorodiméthylsilane sont utilisés comme gaz réactif pour le dépôt de la couche de SiC.

5. Procédé selon au moins une des revendications 1 à 3, caractérisé en ce que le silane SiH₄ avec du toluène C₇H₈ sont utilisés comme gaz réactif pour le dépôt de la couche de SiC.

6. Procédé selon au moins une des revendications 1 à 3, caractérisé en ce que le silane SiH₄ avec du propane C₃H₈ sont utilisés comme gaz réactif pour le dépôt de la couche de SiC.

7. Procédé selon la revendication 4, caractérisé en ce que la couche de SiC est déposée sur une épaisseur de 2,5 µm.

8. Procédé selon la revendication 7, caractérisé en ce que les ions de bore sont implantés dans la couche de SiC à une dose de 10¹⁵ à 10¹⁶/cm à une énergie d'implantation de l'ordre de 150 à 400 keV.

9. Procédé selon la revendication 8, caractérisé en ce que les ions de bore sont implantés dans la couche de SiC à une dose de 10¹⁶/cm à une énergie d'implantation de 170 keV.

10. Procédé selon la revendication 7, caractérisé en ce que les ions de carbone sont implantés dans la couche de SiC à une dose de 10¹⁵ à 5∗10¹⁶/cm à une énergie d'implantation de l'ordre de 150 à 400 keV.

11. Procédé selon la revendication 10, caractérisé en ce que les ions de carbone sont implantés dans la couche de SiC à une dose de 10¹⁶/cm à une énergie d'implantation de l'ordre de 400 keV.

12. Procédé selon la revendication 7, caractérisé en ce que les ions d'azote sont implantés dans la couche de SiC à une dose de 10¹⁵ à 5.10¹⁶/cm à une énergie d'implantation de l'ordre de 150 à 400 keV.

13. Procédé selon la revendication 12, caractérisé en ce que les ions d'azote sont implantés dans la couche de SiC à une dose de 2.10¹⁶/cm à une énergie d'implantation de l'ordre de 400 keV.
